# EUROPEAN PATENT SPECIFICATION

(11) **EP 3 839 400 B1**
(45) Date of publication and mention of the grant of the patent: **24.07.2024**
(21) Application number: 20201772.9
(22) Date of filing: 14.10.2020
(51) Int. Cl.: F28D 15/02

(54) **VAPOR CHAMBER HEATSINK ASSEMBLY**
DAMPFKAMMER-KÜHLKÖRPER-ANORDNUNG
ENSEMBLE DISSIPATEUR THERMIQUE DE CHAMBRE DE VAPEUR

(30) Priority: 16.12.2019 TW 108146062
(43) Date of publication of application: 23.06.2021
(73) Proprietor: Cooler Master Co., Ltd., Taipei City 114065 (TW)
(72) Inventor: LIN, Chia-Yu, 114065 Taipei City (TW); CHENG, Shan-Yin, 114065 Taipei City (TW); LIU, Chien-Ting, 114065 Taipei City (TW)
(74) Representative: Grünecker Patent- und Rechtsanwälte PartG mbB

(56) References cited:
- JP-A- H10 209 355
- US-A1- 2017 023 308
- US-A1- 2018 066 897
- US-A1- 2019 027 424

## Description

### TECHNICAL FIELD

The present invention relates to vapor chamber heatsink assemblies according to the preamble of claim 1. Such an assembly is known from JP H10 209355 A.

### BACKGROUND

During operation of electric and electronic elements, devices and systems, the heat generated thereby must be dissipated quickly and efficiently to keep operating temperature within manufacturer recommended ranges, under, at times, challenging operating conditions. As these elements, devices and systems increase in functionality and applicability, so does the power requirements thereof, this in turn increases cooling requirements.

Several techniques have been developed for extracting heat from electric and electronic elements, devices and systems. One such technique is an air-cooling system, wherein a vapor chamber heatsink assembly is in thermal contact with the elements, devices or systems, transporting heat away therefrom, and then air flowing over the vapor chamber heatsink assembly removes heat from the vapor chamber heatsink assembly. One type of vapor chamber heatsink assembly is a vapor chamber.

A vapor chamber is a type of planar heat pipe, employed individually, or in conjunction with other thermal management systems such as heatsink fins, as an example, for heat spreading. Vapor chambers are vacuum containers that carry heat by evaporation of a working fluid, which is spread by a vapor flow filling the vacuum. The vapor flow eventually condenses over cooler surfaces, and, as a result, the heat is distributed from an evaporation surface (heat flux source interface) to a condensation surface (cooling surface). Thereafter, condensed fluid flows back toward the evaporation surface. A wick structure is often used to facilitate the flow of the condensed fluid back to the evaporation surface keeping it wet for large heat fluxes.

For vapor chambers employed in conjunction with heatsink fins, a plurality of heatsink fins extends from a surface of the vapor chamber. The plurality of heatsink fins increases the rate of convective heat transfer to or from an environment of the vapor chamber heatsink assembly, by increasing the surface area of the heat flux source interface. Heat is transferred from the heat source to the vapor chamber, the vapor chamber to the plurality of heatsink fins and the environment, and the plurality of heatsink fins to the environment.

Generally, for vaper chambers to effectively spread heat via the phase change (liquid-vapor-liquid) mechanism, the area of the cooling surfaces should be larger than the heat flux source interface surfaces, the design of the vapor chambers should hinder deformation and leakage and heat-transmitting efficiency of the vapor chamber should be at a highest. This becomes more difficult to accomplish as the amount of heat flux source interfaces, having a distance therebetween, increase; thus, requiring the dimensions of the vapor chamber to increase. As the dimensions of the vapor chamber increases, so does the dimensions of the plurality of heatsink fins and correspondingly, the weight on the surface of the vapor chamber. Additionally, when there is more than one heat flux source interface, leakage and dry-out occurs, when the temperature of one of the heat flux sources is greater than the temperature of another heat flux source, causing the working fluid to agglomerate closer to the heat flux source with the higher temperature. Thus, dry-out occurs near the lower temperature heat flux source interface, causing the corresponding electric and/or electronic elements, devices and/or systems to overheat, fail or become damaged.

JP H10 209355 A refers to a cooling apparatus for cooling a heating element such as a semiconductor element. The cooling apparatus includes a refrigerant contained and a plurality of radiation fins. The container includes a plurality of columns provided between the heat receiving wall and the heat radiating wall. A peripheral side wall closes the container along its side surfaces. The document discloses several different construction possibilities, like integral construction of the heat radiating wall and the radiation fins or a separate configuration of the radiation fins and the container. Container is closed tightly and contains a predetermined amount of refrigerant. In one embodiment (Fig. 21 and 22), the radiation fins are hollow, but the volume of the hollow portion is smaller than the liquid volume of the refrigerant. The heat transfer members transmit heat from the heat receiving wall to the heat radiating wall and thus does improve the performance of the device. The columns may be formed by the heat radiating wall or the heat receiving wall.

US 2019/027424 A1 refers to a vapor chamber to be used together with a heatsink including fins. The vapor chamber includes a top plate, a bottom plate and a recess portion that is defined between the top plate and the bottom plate. The vapor chamber is filled with a liquid. A plurality of columnar reinforcing structures extend between the top plate and the bottom plate. The structure may be jacketed or sleeved pillars that can be fixed to the top plate or bottom plate. The reinforcing structures are used to reinforce the vapor chamber but also some information is given with regard to the influence of thermal performance of the vapor chamber.

US 2018/066897 A1 relates to a vapor chamber comprising a lower casing, an upper casing member and a working fluid. The lower casing has a rectangular base plate and a side plate erected from the periphery of the base plate. The upper casing member comprises a rectangular substrate, a plurality of fins, and a plurality of support bodies, which are integrally formed with one another. The upper casing member is engaged with the lower casing and then sealed by welding or any other appropriate method, so that the chamber is formed therebetween. The chamber is evacuated and filled with the working fluid. Each support body is preferably erected from the inner wall, and an end surface abuts the base plate of the lower casing. Each support body is preferably in the shape including but not limited to the shape of a long-strip pillar and the long-strip pillars are distributed with an interval apart from one another in the chamber. A flow channel is formed between each support body and the plurality of side plates of the lower casing and provided for circulating the working fluid.

US 2017/023308 A1 discloses a slim vapor chamber VC that includes a first plate and a second plate. The periphery of the second plate is connected with that of the first plate to form a chamber. The chamber is filled with a working fluid and the pressure in the chamber is reduced to vacuum or almost vacuum. The first and/or the second plate include a plurality of supporting structures. The supporting structures in the first region include a plurality of supporting pillars for creating the space to accommodate the expanded working fluid vapor, and the supporting structures in the second region includes a plurality of supporting plates for directing the working fluid vapor to the condenser section. The shape of the cross-section of a supporting pillar can be regular or irregular.

### SUMMARY

The present invention is defined by the features of claim 1. In an embodiment, a vapor chamber heatsink assembly, under vacuum, having a working fluid therein is provided, comprising a plurality of heatsink fins, a vapor chamber, and a lower casing. The plurality of heatsink fins, each, have a fin base, an enhancement portion, and a fin tip, opposite the fin base. The vapor chamber has an upper casing, and a lower casing. The upper casing comprises a mounting surface having a plurality of mounting portions thereon, and an upper chamber surface, opposite the mounting surface. The plurality of heatsink fins are disposed on the upper casing at the plurality of mounting portions, respectively. The lower casing comprises a lower chamber surface, and a contact surface, opposite the lower chamber surface. The upper chamber surface is liquid tight attached to the lower chamber surface, and the upper and lower chamber surfaces form a plurality of obstructers defining a plurality of braided channels therearound in direct or indirect communication thereamong. The working fluid travels through the plurality of braided channels unobstructed. Each of the plurality of heatsink fins comprises a plurality of channel extensions therein in direct or indirect communication thereamong and in direct or indirect communication with the plurality of braided channels of the upper and lower chamber surfaces. In some embodiments, at least two of the plurality of channel extensions of each of the plurality of heatsink fins is in direct communication with at least two of the plurality of braided channels, respectively. In some embodiments, at least two of the plurality of channel extensions of each of the plurality of heatsink fins are parallel disposed and evenly spaced apart, having a same flow volume and shape.

In some embodiments, the vapor chamber heat assembly further comprises a first heat source, and a second heat source. The first and second heat sources are mounted to the contact surface of the lower chamber surface, each opposite to at least two opposing directions of one of the plurality of braided channels of the upper and lower chamber surfaces, respectively.

In some embodiments, the power requirement and maximum operating temperature allowance of the first heat source is less than the power requirement and maximum operating temperature allowance of the second heat source, whereby, during operation, the working fluid travels through the at least two opposing directions of the plurality of braided channels opposite to the mounted first and second heat sources, respectively, while concurrently, being hindered to agglomerate to the second heat source via the plurality of obstructers.

In some embodiments, the shape of each of the plurality of obstructers is a four-sided shape, and each is separated by coinciding plurality of braided channels of neighboring plurality of obstructers or perimeter walls therearound, whereby at least one corner of each of the plurality of obstructers define a corner of a cross-section of the plurality of braided channels.

In some embodiments, the amount of the plurality of obstructers is thirty. In some embodiments, the amount of the plurality of obstructers is less than thirty. In some embodiments, the amount of the plurality of obstructers is greater than thirty.

In some embodiments, the amount of the plurality of obstructers is two and the plurality of braided channels comprises one direct communication plurality of braided channels having at least four curved flow path changes. In some embodiments, the plurality of braided channels comprises seven curved flow path changes.

In some embodiments, the plurality of obstructers defining the plurality of braided channels is formed within the upper and lower chamber surfaces, respectively. In some embodiments, the plurality of obstructers defining plurality of braided channels is formed within the upper chamber surface, respectively. In some embodiments, the plurality of obstructers defining the plurality of braided channels is formed within the lower chamber surface, respectively.

In some embodiments, a side of each of the plurality of braided channels opposite the contact surface of the lower chamber surface comprises a wick structure thereon, respectively. In some embodiments, the wick structure comprises at least one of a porous polymer wick structure, micro groove wick structure, metal mesh wick structure, sintered powder wick structure or sintered ceramic powder wick structure, or any combination of the foregoing.

In some embodiments, each of the plurality of braided channels comprises a plurality of supporting channel walls and a plurality of filler reserve gaps, the plurality of filler reserve gaps configured to contain excess filler material following liquid tight attachment of the upper chamber surface to the lower chamber surface, the plurality of supporting channel walls is on all sides of the plurality of braided channels, separated from the plurality of obstructers and perimeter walls via the plurality of filler reserve gaps.

In some embodiments, each of the plurality of heatsink fins is disposed on the upper casing at the plurality of mounting portions via brazing, respectively. In some embodiments, the plurality of heatsink fins is integrally formed on the upper casing at the plurality of mounting portions.

### BRIEF DESCRIPTION OF THE DRAWINGS

Unless specified otherwise, the accompanying drawings illustrate aspects of the innovative subject matter described herein. Referring to the drawings, wherein like reference numerals indicate similar parts throughout the several views, several examples of vapor chamber heatsink assembly systems and methods incorporating aspects of the presently disclosed principles are illustrated by way of example, and not by way of limitation.
Fig. 1A is a schematic perspective second view of a vapor chamber heatsink assembly.
Fig. 1B is a schematic perspective first view of the vapor chamber heatsink assembly of Fig. 1A.
Fig. 1C is a schematic exploded view of the vapor chamber heatsink assembly of Fig. 1A.
Fig. 2 is schematic perspective third view of an upper casing and a plurality of heatsink fins of the vapor chamber heatsink assembly of Fig. 1A.
Fig. 3A is schematic perspective fourth view of a lower casing of the vapor chamber heatsink assembly of Fig. 1A.
Fig. 3B is schematic perspective fifth view of the lower casing of Fig. 3A.
Fig. 3C is schematic perspective first view of the lower casing of Fig. 3A.
Fig. 4 is schematic partial cross-sectional view of the vapor chamber heatsink assembly of Fig. 1A.
Fig. 5 is schematic partial cross-sectional view of an alternative vapor chamber heatsink assembly.
Fig. 6 is schematic partial cross-sectional view of another alternative vapor chamber heatsink assembly.
Fig. 7A is schematic prospective first view of yet another alternative vapor chamber heatsink assembly.
Fig. 7B is schematic prospective fourth view of the yet another alternative vapor chamber heatsink assembly of Fig. 7A.
Fig. 7C is schematic prospective sixth view of the yet another alternative vapor chamber heatsink assembly of Fig. 7A.
Fig. 8 is schematic perspective fourth view of an upper casing and a plurality of heatsink fins of the yet another vapor chamber heatsink assembly of Fig. 7A.
Fig. 9 is schematic perspective fifth view of a lower casing of another alternative vapor chamber heatsink assembly.
Fig. 10 is schematic internal seventh view of yet another alternative vapor chamber heatsink assembly, according to an example embodiment of the present invention.

### DETAILED DESCRIPTION

The following describes various principles related to vapor chamber heatsink assembly systems by way of reference to specific examples of vapor chambers, heatsinks, and heatsink fins including specific arrangements and examples of metal sheets, plurality of braided channels and obstructers embodying innovative concepts. More particularly, but not exclusively, such innovative principles are described in relation to selected examples of vapor chamber heatsink assembly systems and well-known functions or constructions are not described in detail for purposes of succinctness and clarity. Nonetheless, one or more of the disclosed principles can be incorporated in various other embodiments of vapor chamber heatsink assembly systems to achieve any of a variety of desired outcomes, characteristics, and/or performance criteria.

Thus, vapor chamber heatsink assembly systems andhaving attributes that are different from those specific examples discussed herein can embody one or more of the innovative principles, and can be used in applications not described herein in detail. Accordingly, embodiments of vapor chamber heatsink assembly systems not described herein in detail also fall within the scope of this disclosure, as will be appreciated by those of ordinary skill in the relevant art following a review of this disclosure.

Example embodiments as disclosed herein are directed to vapor chamber heatsink assemblies, under vacuum, and having a working fluid therein. In an embodiment, a vapor chamber heatsink assembly comprising a plurality of heatsink fins and a vapor chamber is provided. The vapor chamber comprises an upper and lower casing having an upper and lower chamber surface, respectively. The upper and lower chamber surfaces define a plurality of obstructers forming a plurality of braided channels therearound. When heat from a greater temperature heat source and a lower temperature heat source is applied to respective contact surfaces of the lower casing, via the plurality of obstructers and plurality of braided channels, the working fluid and liquid vapor slugs/bubbles travel therethrough, providing an effective phase change mechanism to the greater temperature heat source, while concurrently, hindering agglomeration of working fluid thereto. An effective phase change mechanism is also concurrently provided to the lower temperature heat source due to the non-agglomeration of working fluid to the greater temperature heat source.

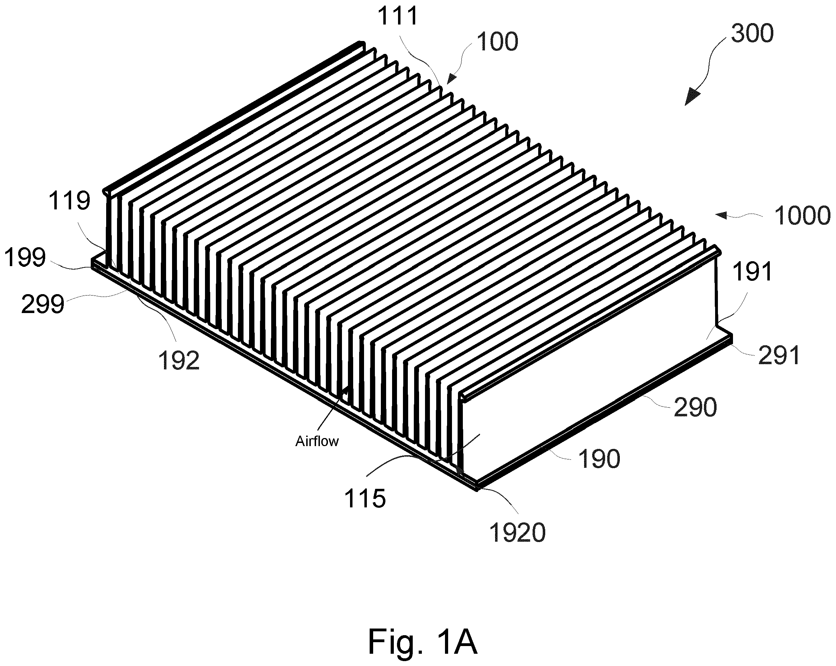

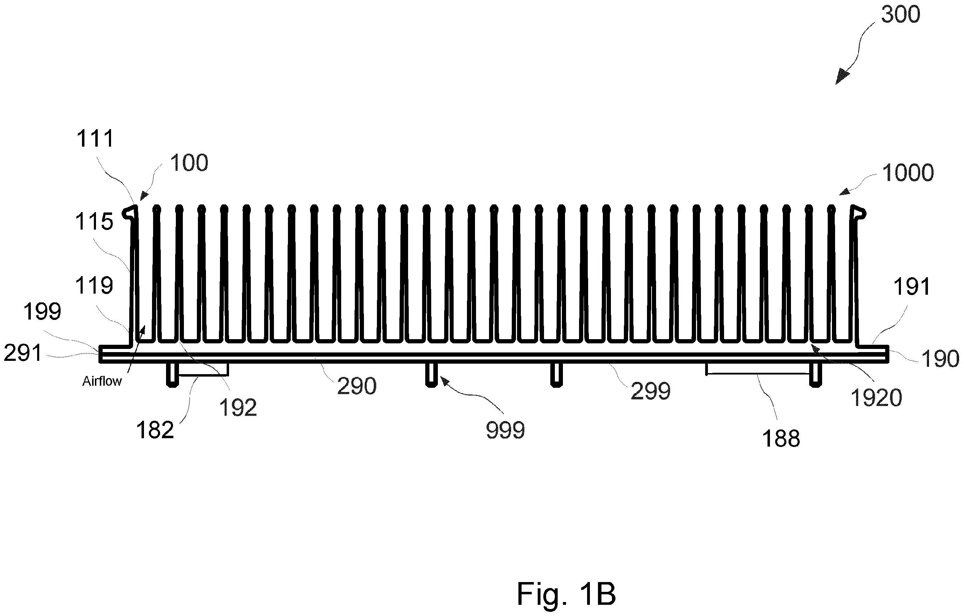

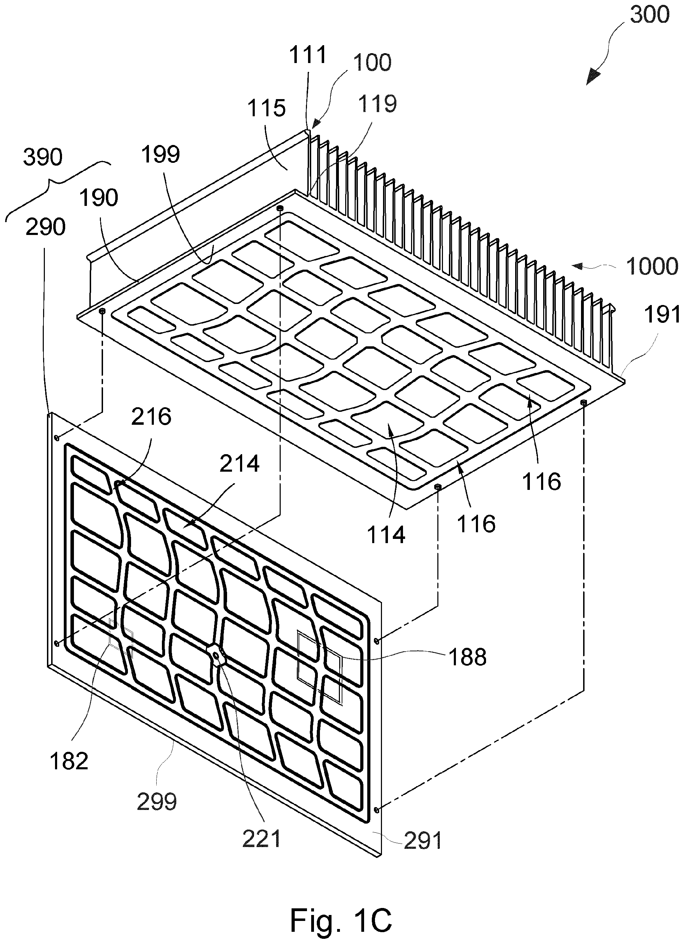

Fig. 1A is a schematic perspective second view of a vapor chamber heatsink assembly 300. Fig. 1B is a schematic perspective first view of the vapor chamber heatsink assembly 300 of Fig. 1A. Fig. 1C is a schematic exploded view of the vapor chamber heatsink assembly 300 of Fig. 1A. The vapor chamber heatsink assembly 300 may be employed to cool at least one of an electric and/or electronic element, device and/or system. Referring to Figs. 1A to 1C, the vapor chamber heatsink assembly 300 comprises a plurality of heatsink fins 1000 and a vapor chamber 390. Each heat sink fin 100 of the plurality of heatsink fins 1000 comprises a fin base 119, an enhancement portion 115, and a fin tip 111, opposite the fin base 119. The vapor chamber 390 has an upper casing 190 and a lower casing 290. The upper casing 190 comprises a mounting surface 191 and an upper chamber surface 199, opposite the mounting surface 191. The mounting surface 191 has a plurality of mounting portions 1920 thereon, substantially parallel thereamong and evenly spaced apart. The lower casing 290 comprises a lower chamber surface 291 and a contact surface 299, opposite the lower chamber surface 291.

Each fin base 119 of each heat sink fin 100 may be thermally and mechanically, permanently attached to each mounting portion 192 by brazing techniques known to those of ordinary skill in the relevant art; however, the embodiments are not limited thereto. Other appropriate methods may be employed, as long as heat may be efficiently and effectively transferred from the vapor chamber 390 to the plurality of heatsink fins 1000. In some embodiments, each fin base 119 may be hemmed, reinforcing the strength thereof and increasing the surface area for conductive heat transfer from the vapor chamber 390 to the plurality of heatsink fins 1000. In some embodiments, the plurality of heatsink fins 1000 may be integrally formed with the upper casing 190 of the vapor chamber 390. Any technique known to those of ordinary skill in the relevant art may be employed for the manufacturing of the vapor chamber heatsink assembly 300 comprising the plurality of heatsink fins 1000 and vapor chamber 390 and the embodiments are not limited.

The area occupied by the plurality of heatsink fins 1000 on the mounting surface 191 may be varied depending upon application and design requirements. As an example, the area may be smaller, resulting in a non-occupied area of the mounting surface 191 on one or more than one side thereof, or the area may be larger, extending outward over one or more side edges of the mounting surface 191, and the embodiments are not limited thereto.

One or more heat sources of electric and/or electronic elements, devices and/or systems, and/or any combination thereof, may be attached to the contact surface 299, for example and not to be limiting, by fastening or other means known to those of ordinary skill in the relevant art. As long as heat may be efficiently and effectively transferred from the one or more heat sources to the vapor chamber 390.

In some embodiments, a first heat source 182 and a second heat source 188 is attached to the upper chamber surface 199 of the vapor chamber 390. As an example, and not to be limiting, the power requirement and maximum operating temperature allowance of the first heat source 182 is less than that of the second heat source 188 and the first heat source 182 is disposed at a distance away from the second heat source 188.

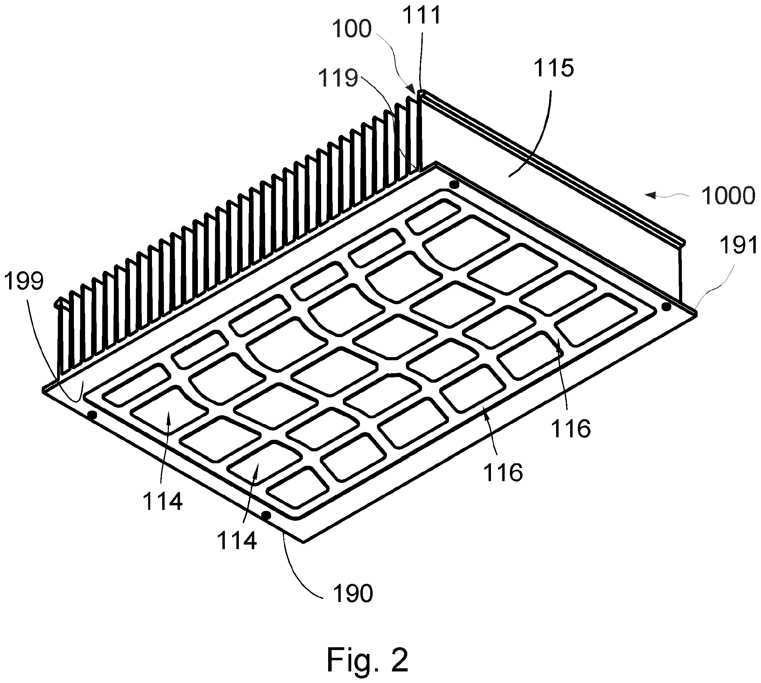

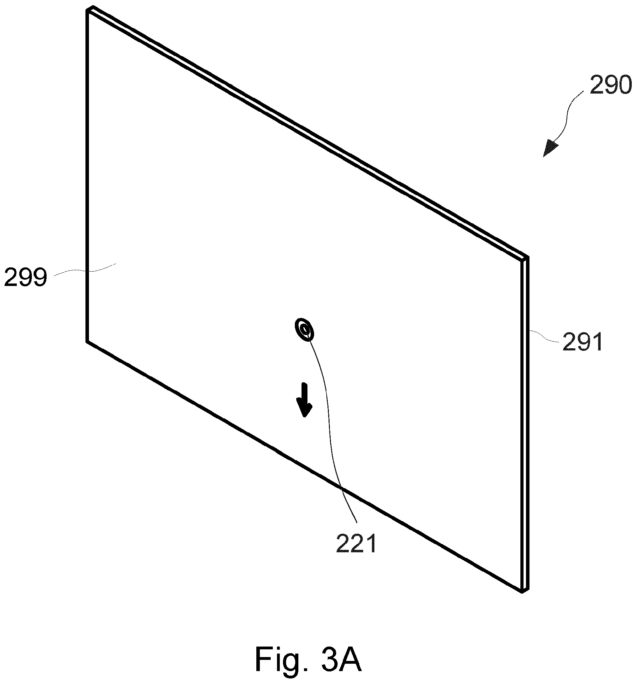

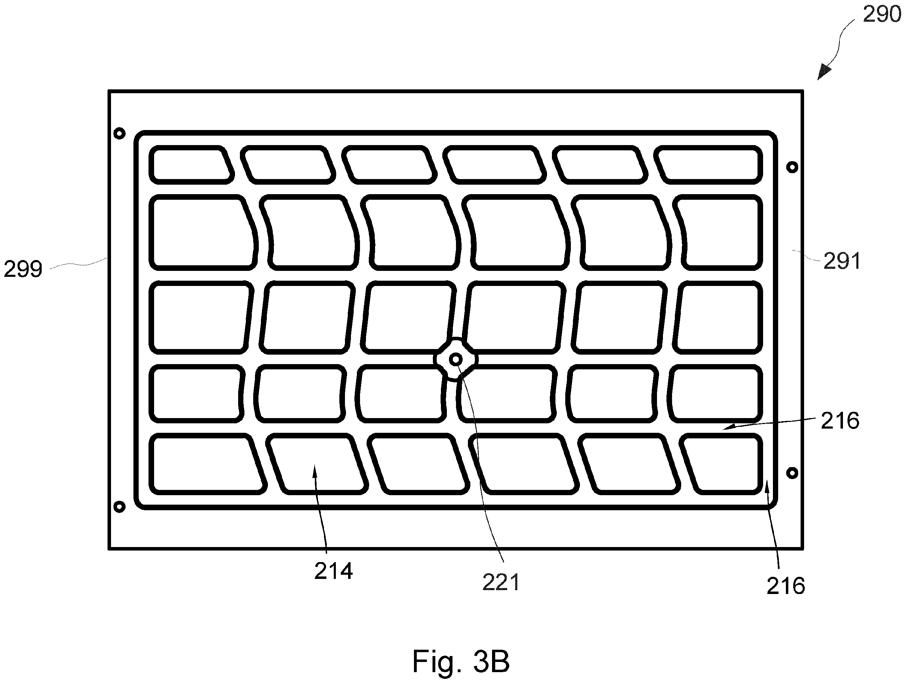

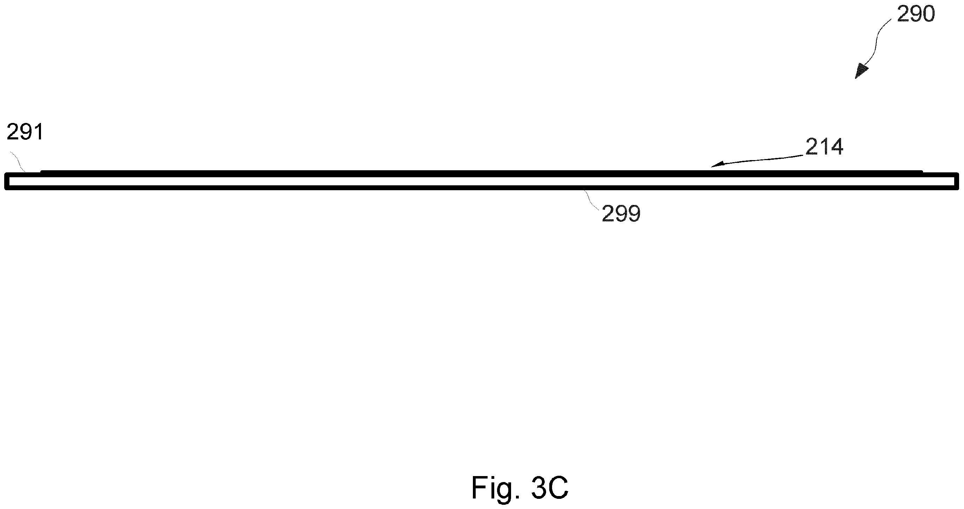

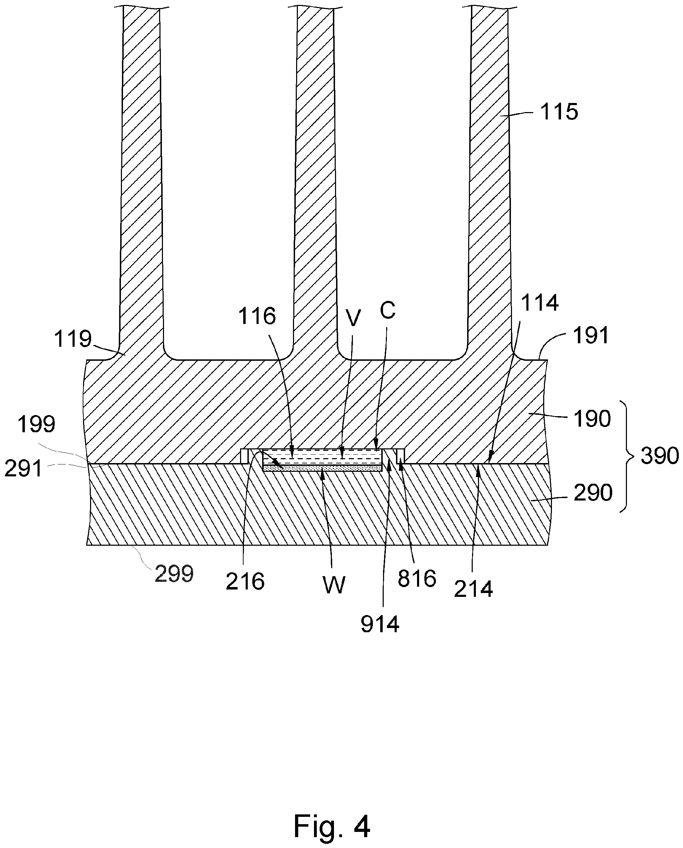

Fig. 2 is schematic perspective third view of an upper casing and a plurality of heatsink fins of the vapor chamber heatsink assembly of Fig. 1A. Fig. 3A is schematic perspective fourth view of a lower casing of the vapor chamber heatsink assembly of Fig. 1A. Fig. 3B is schematic perspective fifth view of the lower casing of Fig. 3A. Fig. 3C is schematic perspective first view of the lower casing of Fig. 3A. Fig. 4 is schematic partial cross-sectional view of the vapor chamber heatsink assembly of Fig. 1A. Referring to Figs. 2 to 4, and referring to Figs. 1A to 1C, in some embodiments, the vapor chamber 390 further comprises a plurality of obstructers 114, 214 forming a plurality of braided channels 116, 216 therearound. The shape of the plurality of obstructers 114, 214 is generally four-sided having a flowing pitch; however, the embodiments are not limited thereto. Those of ordinary skill in the relevant art may readily appreciate that the shape and pitches of the plurality of obstructers 114, 214 may be varied with larger and/or smaller pitches and/or any combination thereof, depending upon application and design requirements and the embodiments are not limited thereto. As long as the plurality of obstructers 114, 214 forms the plurality of braided channels 116, 216 therearound, such that the working fluid and liquid vapor slugs/bubbles travel through the plurality of braided channels 116, 216 in an unobstructed manner, providing the effective phase change (liquid-vapor-liquid) mechanism. As an example, 'obstructed manner' of the plurality of braided channels 116, 216 may comprise 45°degree or smaller sharp turn angles within the plurality of braided channels 116, 216 path. As an example, a 'path' of the plurality of braided channels 116, 216 comprises a generally same direction prior to and after any adjustment in direction.

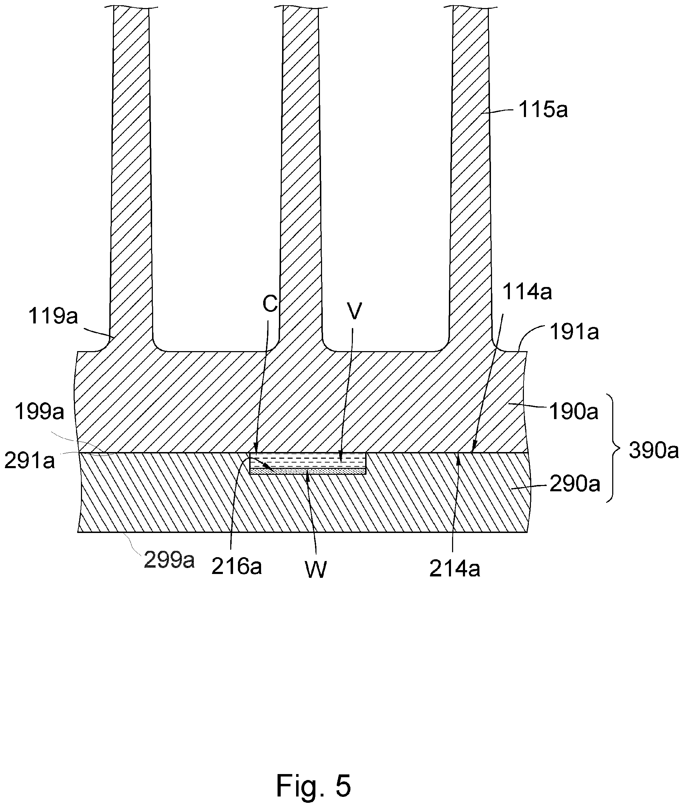

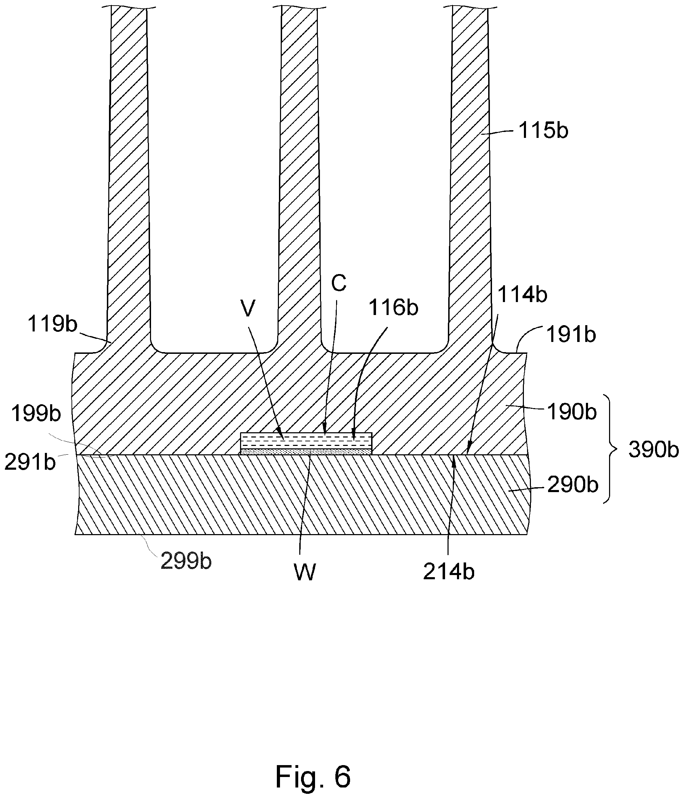

In some embodiments, the plurality of obstructers 114, 214 are formed by both the upper chamber surface 199 and lower chamber surface 291 and the plurality of braided channels 116, 216 are formed by corresponding grooved surfaces therewithin, respectively; however, the embodiments are not limited thereto. In an alternative embodiment, the lower chamber surface 291a comprises grooved surfaces forming the plurality of braided channels 216a around the plurality of obstructers 214a following attachment of the upper chamber surface 199a thereto. Fig. 5 is schematic partial cross-sectional view of an alternative vapor chamber heatsink assembly. Referring to Fig. 5, and referring to Figs. 1A to 4, the upper chamber surface 199a is generally flat and is liquid tight secured to the lower chamber surface 291a having grooved surfaces forming the plurality of braided channels 216a around the plurality of obstructers 214a. In another alternative embodiment, the upper chamber surface 191b comprises grooved surfaces forming the plurality of braided channels 116b around the plurality of obstructers 114b following attachment of the lower chamber surface 291b thereto. Fig. 6 is schematic partial cross-sectional view of another alternative vapor chamber heatsink assembly. Referring to Fig. 6, and referring to Figs. 1A to 5, the lower chamber surface 291b is generally flat and is liquid tight secured to the upper chamber surface 199b having grooved surfaces forming the plurality of braided channels 116b around the plurality of obstructers 114b. As long as the plurality of obstructers form the plurality of braided channels, therearound.

Referring to Fig. 4, and referring to Figs. 1A to 3 and Figs. 5 and 6, in an alternative embodiment, the grooved surface of the plurality of braided channels 216 of the lower chamber surface 291 comprises a plurality of supporting channel walls 914 on all sides forming the plurality of braided channels 116, respectively. The plurality of supporting channel walls 914 correspond to the grooved surface of the plurality of braided channels 116 of the upper chamber surface 199, and has a generally flat top which is liquid tight secured to the grooved surface of the plurality of braided channels 116. The plurality of supporting channel walls 914 defines the plurality of braided channels 116, 216 and a plurality of filler reserve gaps 816. The plurality of filler reserve gaps is between the plurality of supporting channel walls 914 and the walls of the plurality of obstructers 114 of the upper chamber surface 199. The plurality of filler reserve gaps 816 is configured to contain excess filler material following liquid tight attachment of the upper chamber surface 199 to the lower chamber surface 291 and is not limited to the embodiment of Fig. 4. As an example, in the alternative vapor chamber heatsink assembly of Fig. 5, the upper chamber surface 199a comprises a plurality of supporting channel walls (not shown) on all sides forming the plurality of braided channels 216a, respectively, of the plurality of obstructers 214a. The plurality of supporting channel walls correspond to the grooved surface of the plurality of braided channels 216a of the lower chamber surface 291a, and has a generally flat top which is liquid tight secured to the grooved surface of the plurality of braided channels 216a. The plurality of supporting channel walls defines the plurality of braided channels 216a and a plurality of filler reserve gaps (not shown) between the plurality of supporting channel walls and the walls of the plurality of braided channels 216a formed by the plurality of obstructers 214a of the lower chamber surface 291a.

In some embodiments, the flow volume and shape of the plurality of braided channels are generally even thereacross, respectively; however, the embodiments are not limited thereto. Those of ordinary skill in the relevant art may readily appreciate that the vertical and horizontal dimensions and shapes may be varied, respectively, depending upon application and design requirements. As long as the plurality of braided channels is in direct or indirect communication thereamong and the working fluid and liquid vapor slugs/bubbles travel through the plurality of braided channels in an unobstructed manner, providing the effective phase change (liquid-vapor-liquid) mechanism.

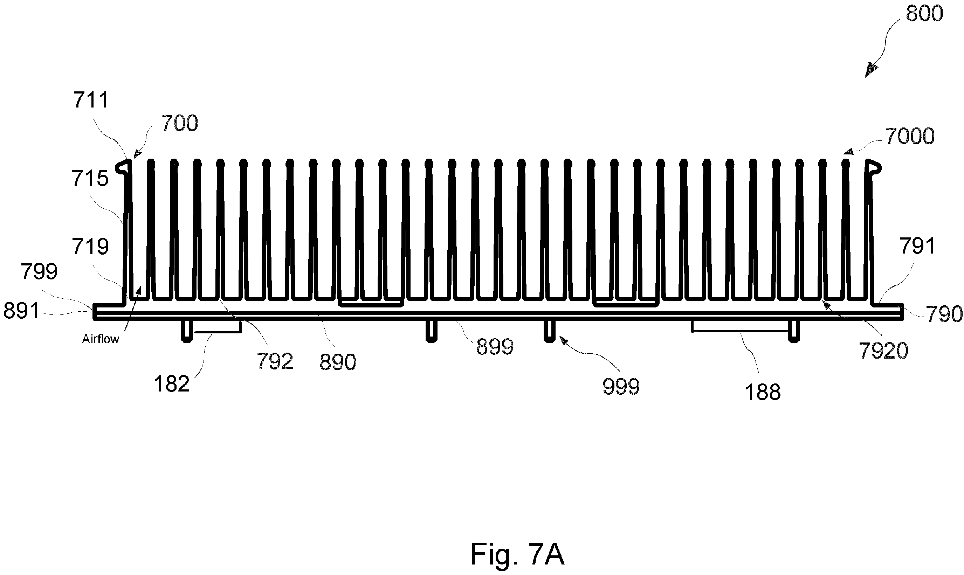

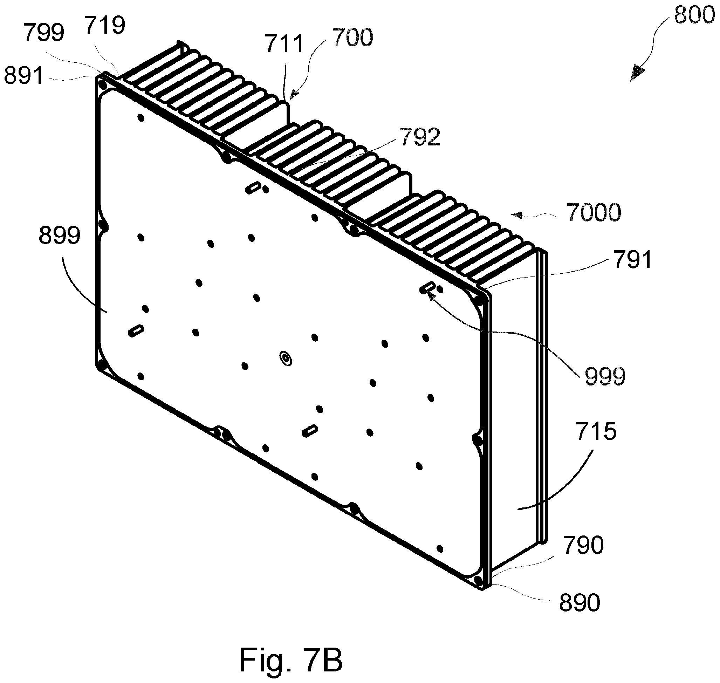

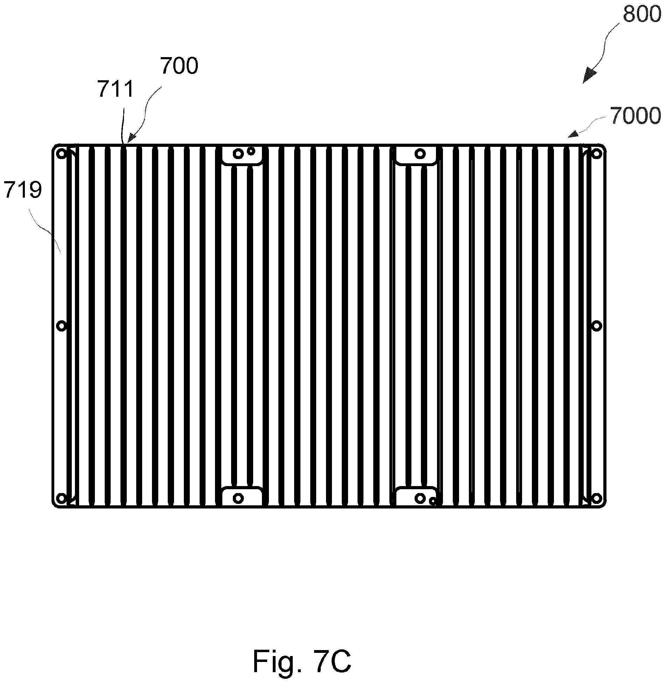

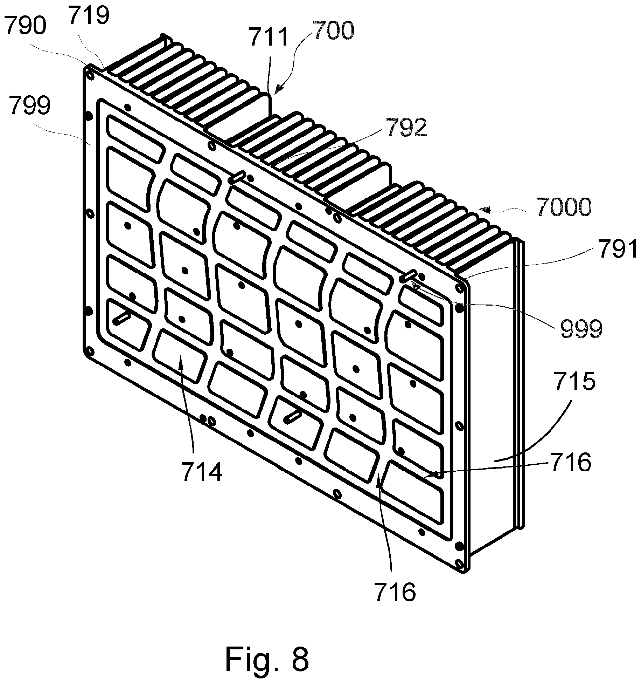

In some embodiments, the length of the plurality of heatsink fins 1000 on the mounting surface 191 of the vapor chamber 390 is generally the same; however, the embodiments are not limited thereto. Fig. 7A is schematic prospective first view of yet another alternative vapor chamber heatsink assembly 800. Fig. 7B is schematic prospective fourth view of the yet another alternative vapor chamber heatsink assembly 800 of Fig. 7A. Fig. 7C is schematic prospective sixth view of the yet another alternative vapor chamber heatsink assembly 800 of Fig. 7A. Fig. 8 is schematic perspective fourth view of an upper casing 790 and a plurality of heatsink fins 700 of the yet another vapor chamber heatsink assembly 800 of Fig. 7A. Referring to Figs. 7A to 8, and referring to Figs. 1A to 6, the area occupied by the plurality of heatsink fins 7000 on the mounting surface 191 is varied to accommodate for attachment of the vapor chamber heatsink assembly 800 to one or more heat sources of electric and/or electronic elements, devices and/or systems. As an example, alignment pegs, rivets and/or screws are employed for attachment. Thus, the length of four (4) of the plurality of heatsink fins 7000 is shorter than that of the other plurality of heatsink fins 7000. As long as heat may be efficiently and effectively transferred from the one or more heat sources to the vapor chamber 790.

Other features and principles of the yet another alternative vapor chamber heatsink assembly 800 is generally the same as and described in detail in the embodiments of the vapor chamber heatsink assembly 300 above, and for sake of brevity, will not repeated hereafter.

In some embodiments, the vapor chamber, is under vacuum, and has a working fluid therein. The working fluid is distributed naturally in the form of liquid vapor slugs/bubbles throughout the plurality of braided channels. The plurality of braided channels comprises evaporator regions, condenser regions and vapor flow regions extending from the evaporator regions to the condenser regions. When heat from at least a first heat source 182 and at least a second heat source 188 is applied to respective contact surface portions of the lower casing, the heat converts the working fluid to vapor and the vapor bubbles become larger within the respective evaporator regions. Via the plurality of obstructers and plurality of braided channels, the working fluid and liquid vapor slugs/bubbles travel through the plurality of braided channels, providing an effective phase change (liquid-vapor-liquid) mechanism to the greater power and operating temperature second heat source 188, in at least two opposing plurality of braided channels directions, while concurrently, hindering agglomeration of the working fluid thereto. Thus, an effective phase change (liquid-vapor-liquid) mechanism to the lesser power and operating temperature first heat source 182 is concurrently provided, in at least two opposing directions of the plurality of braided channels directions, mitigating dry-out from occurring which may cause corresponding electric and/or electronic elements, devices and/or systems to overheat, fail or be damaged. Meanwhile, at the condenser regions, heat is being removed and the bubbles are reducing in size, providing the effective phase change (liquid-vapor-liquid) mechanism. Additionally, via the plurality of obstructers and plurality of braided channels, when an optimal working fluid filling ratio is of between around 40% to 80%, the amount of working fluid for efficient and effective thermal performance of vapor chamber heatsink assemblies of the embodiments is reduced by 40% to 60% when compared to a vapor chamber heatsink assembly that does not comprise the plurality of obstructers and plurality of braided channels. Weight of the vapor chamber heatsink assembly is reduced. Furthermore, via the dimensions of the plurality of obstructers in relation to the plurality of braided channels, the mounting surface of the upper casing may withstand a heavier weight thereon, decreasing the probability of deformation and/or collapsing of the vapor chamber heatsink assembly, which would result in leakage of the working fluid and eventual dry-out. Thus, facilitating manufacturing of larger sized vapor chamber heatsink assemblies having a plurality of heatsink fins thereon for efficient and effective thermal performance of electric and/or electronic elements, devices and/or systems.

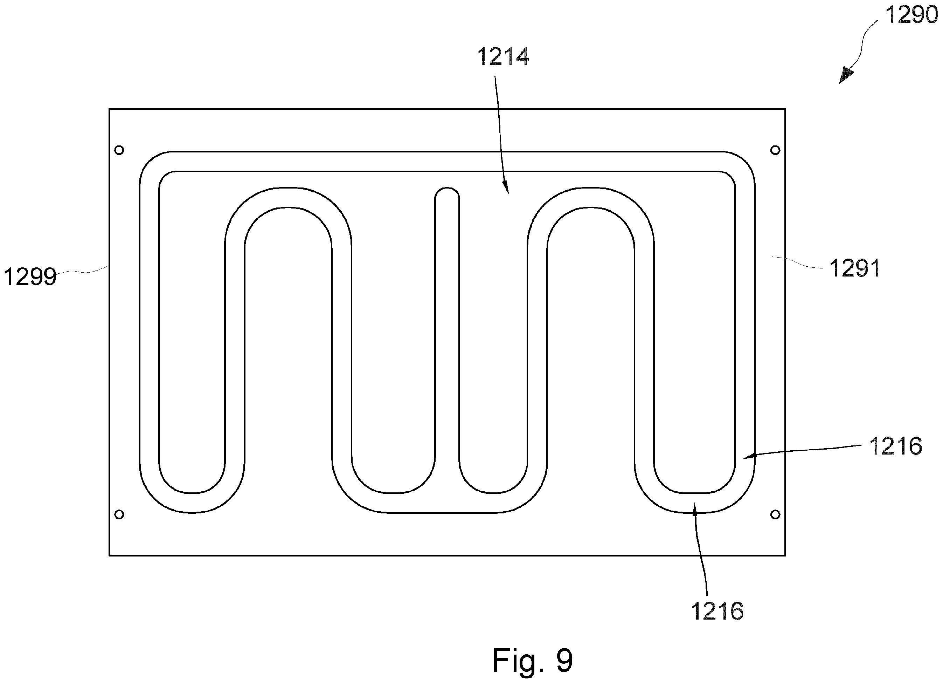

Those of ordinary skill in the relevant art may readily appreciate that the shape and dimensions of the plurality of obstructers forming the plurality of braided channels may be varied, forming the plurality of braided channels in a straighter, wavier, funnel-like and/or spreading-like shape, and/or any combination thereof, depending upon application and design requirements and the embodiments are not limited thereto. As long as the plurality of braided channels is in direct or indirect communication thereamong and the working fluid and liquid vapor slugs/bubbles travel through the plurality of braided channels in an unobstructed manner, providing the effective phase change (liquid-vapor-liquid) mechanism. Fig. 9 is schematic perspective fifth view of a lower casing 1290 of another alternative vapor chamber heatsink assembly. Referring to Fig. 9, and referring to Figs. 1A to 8, the lower casing 1290 comprises a lower chamber surface 1291 and a contact surface 1299, opposite the lower chamber surface 1291. The lower chamber surface 1291 comprises grooved surfaces forming a plurality of directed channels 1216 around obstructer walls 1214 following attachment of an upper chamber surface (not shown) thereto. The upper chamber surface is generally flat and is liquid tight secured to the lower chamber surface 1291. Working fluid and liquid vapor slugs/bubbles travel through the plurality of directed channels 1216 in an unobstructed manner, providing an effective phase change (liquid-vapor-liquid) mechanism. The plurality of directed channels 1216 assures that the liquid vapor slugs/bubbles travel to the most efficient and effective condensation surfaces (cooling surfaces), furthest away from the evaporation surfaces (heat flux source interfaces) for maximum heat dissipation and thermal performance.

Other features and principles of the another alternative vapor chamber heatsink assembly is generally the same as and described in detail in the embodiments of the vapor chamber heatsink assembly 300 above, and for sake of brevity, will not repeated hereafter.

In some embodiments, the vapor chamber and each heat sink fin of the plurality of heatsink fins is made of aluminum, or an aluminum-alloy or the like and suitable for utilizing a brazing technique for thermal and mechanical, permanent brazing of each fin base of each heat sink fin to each mounting portion; however, the embodiments are not limited thereto. The vapor chamber and each heat sink fin may also be made of copper, or a copper-alloy or the like, or other malleable metal heat conducting material having a relatively high thermal conductivity depending upon application and design requirements. As long as each fin base may be thermally and mechanically, permanently mounted to each mounting portion and/or integrally formed therewith.

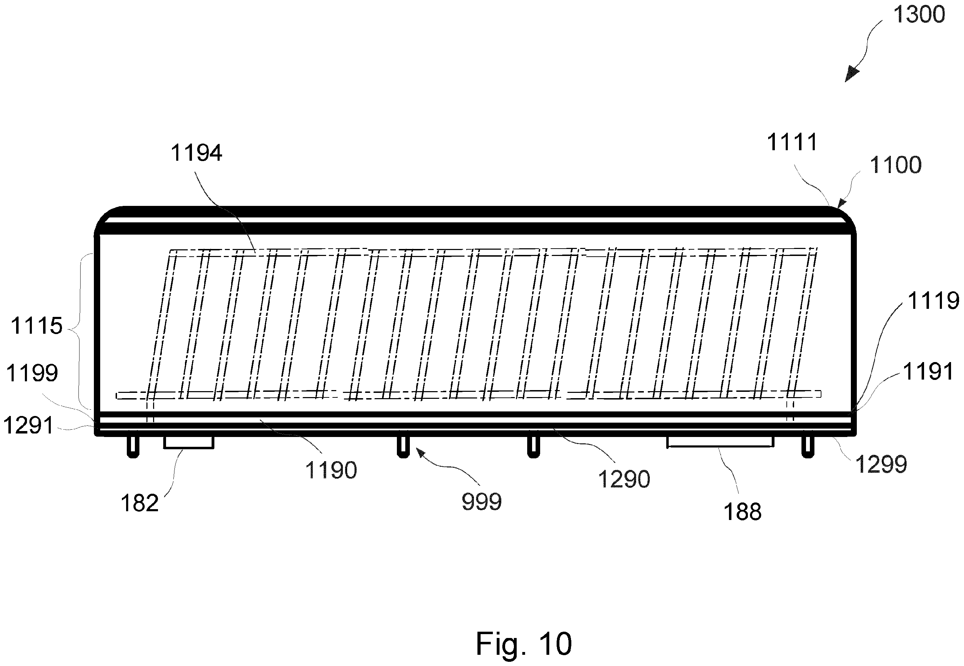

In some embodiments, each heat sink fin of the plurality of heatsink fins is made of a solid malleable metal heat conducting material having a relatively high thermal conductivity; however, the embodiments are not limited thereto. In yet another alternative embodiment, each heat sink fin of the plurality of heatsink fins comprises a plurality of channel extensions therein. Fig. 10 is schematic internal view of a vapor chamber heatsink assembly 1300, according to the present invention. Referring to Fig. 10, and referring to Figs. 1A to 9, an enhancement portion 1115 of each heat sink fin 1100 of the plurality of heatsink fins comprises a plurality of channel extensions 1194 therein. Working fluid and liquid vapor slugs/bubbles travelling through the plurality of braided channels of the vapor chamber in an unobstructed manner, may also travel through the plurality of channel extensions 1194, extending the distance away from the evaporation surfaces (heat flux source interfaces) and for maximum heat dissipation and thermal performance. The plurality of channel extensions 1194 is substantially parallel thereamong, has generally the same flow volume and shape, and is evenly spaced apart; however the embodiments are not limited thereto. Those of ordinary skill in the relevant art may readily appreciate that the amount, vertical and horizontal dimensions and shapes, and design within each heat sink fin 1100 may be varied, respectively, depending upon application and design requirements. As long as the plurality of channel extensions 1194 is in direct or indirect communication thereamong and at least two of the plurality of channel extensions 1194 is in direct communication with the plurality of braided channels, whereby the working fluid and liquid vapor slugs/bubbles may travel through the plurality of braided channels in an unobstructed manner and to the plurality of channel extensions 1194, providing the effective phase change (liquid-vapor-liquid) mechanism.

In some embodiments, the vapor chamber having an upper casing and a lower casing is under vacuum, and has a working fluid therein. In alternative embodiments, the vapor chamber having an upper casing and a lower casing has an inlet and an outlet, having working fluid flowing therein and thereabout, and the embodiments are not limited.

In some embodiments, if a stamping process or the like is used to form each vapor chamber or heat sink fin, any bonding method known by those skilled in the relevant art, such as ultrasonic welding, diffusion welding, laser welding and the like, can be employed to bond and integrally form the vapor chamber. As long as a vacuum seal can be achieved.

In some embodiments, if a stamping process or the like is employed, depending upon dimensions and application, axial or circumferential wick structures, having triangular, rectangular, trapezoidal, reentrant, etc. cross-sectional geometries, may be formed on inner surfaces of the at least one condensation channel, at least one connecting channel, and at least one evaporation channel, and plurality of braided channels. Referring to Figs. 4 to 6, a wick structure W may be used to facilitate the flow of condensed fluid by capillary force back to the evaporation surface, keeping the evaporation surface wet for large heat fluxes. The wick structure may comprise at least one of a porous polymer wick structure, micro groove wick structure, metal mesh wick structure, sintered powder wick structure or sintered ceramic powder wick structure, or any combination of the foregoing.

In some embodiments, the working fluid is made of acetone; however, the embodiments are not limited thereto. Other working fluids can be employed, as can be common for those skilled in the relevant art. As a non-limiting example, the working fluid can comprise cyclopentane or n-hexane. As long as the working fluid can be vaporized by a heat source and the vapor can condense back to the working fluid and flow back to the heat source.

A vapor chamber heatsink assembly, under vacuum, having a working fluid therein, comprising a plurality of heatsink fins and a vapor chamber is provided. The vapor chamber comprises an upper and lower casing having an upper and lower chamber surface, respectively. The upper and lower chamber surfaces define a plurality of obstructers forming a plurality of braided channels therearound. When heat from a greater temperature heat source and a lower temperature heat source is applied to respective contact surfaces of the lower casing, via the plurality of obstructers and plurality of braided channels, the working fluid and liquid vapor slugs/bubbles travel therethrough, providing an effective phase change mechanism to the greater temperature heat source, while concurrently, hindering agglomeration of working fluid thereto. An effective phase change mechanism is also concurrently provided to the lower temperature heat source due to the non-agglomeration of working fluid to the greater temperature heat source.

In the embodiments, the plurality of braided channels comprises evaporator regions, condenser regions and vapor flow regions extending from the evaporator regions to the condenser regions. When heat from a first heat source, requiring less power and operating temperature than a second heat source, along with heat from the second heat source is applied to respective contact surface portions of the lower casing, the heat converts the working fluid to vapor and the vapor bubbles become larger within the respective evaporator regions. Via the plurality of obstructers and plurality of braided channels, the working fluid and liquid vapor slugs/bubbles travel through the plurality of braided channels, providing an effective phase change (liquid-vapor-liquid) mechanism to the greater power and operating temperature second heat source, in at least two opposing plurality of braided channels directions, while concurrently, hindering agglomeration of the working fluid thereto. Thus, an effective phase change (liquid-vapor-liquid) mechanism to the lesser power and operating temperature first heat source is concurrently provided, in at least two opposing directions of the plurality of braided channels directions, mitigating dry-out from occurring which may cause corresponding electric and/or electronic elements, devices and/or systems to overheat, fail or be damaged. Meanwhile, at the condenser regions, heat is being removed and the bubbles are reducing in size, providing an effective phase change (liquid-vapor-liquid) mechanism. Additionally, via the plurality of obstructers and plurality of braided channels, when an optimal working fluid filling ratio is of between around 40% to 80%, the amount of working fluid for efficient and effective thermal performance of vapor chamber heatsink assemblies of the embodiments is reduced by 40% to 60% when compared to a vapor chamber heatsink assembly that does not comprise the plurality of obstructers and plurality of braided channels. Weight of the vapor chamber heatsink assembly is reduced. Furthermore, via the dimensions of the plurality of obstructers in relation to the plurality of braided channels, the mounting surface of the upper casing may withstand a heavier weight thereon, decreasing the probability of deformation and/or collapsing of the vapor chamber heatsink assembly, which would result in leakage of the working fluid and eventual dry-out. Thus, facilitating manufacturing of larger sized vapor chamber heatsink assemblies having a plurality of heatsink fins thereon for efficient and effective thermal performance of electric and/or electronic elements, devices and/or systems.

The presently disclosed inventive concepts are not intended to be limited to the embodiments shown herein, but by the scope of protection as defined in the claims. Directions and references to an element, such as "up," "down,", "upper," "lower," "horizontal," "vertical," "left," "right," and the like, do not imply absolute relationships, positions, and/or orientations. Terms of an element, such as "first" and "second" are not literal, but, distinguishing terms. As used herein, terms "comprises" or "comprising" encompass the notions of "including" and "having" and specify the presence of elements, operations, and/or groups or combinations thereof and do not imply preclusion of the presence or addition of one or more other elements, operations and/or groups or combinations thereof. Sequence of operations do not imply absoluteness unless specifically so stated. Reference to an element in the singular, such as by use of the article "a" or "an", is not intended to mean "one and only one" unless specifically so stated, but rather "one or more". As used herein, "and/or" means "and" or "or", as well as "and" and "or." As used herein, ranges and subranges mean all ranges including whole and/or fractional values therein and language which defines or modifies ranges and subranges, such as "at least," "greater than," "less than," "no more than," and the like, mean subranges and/or an upper or lower limit. All structural and functional equivalents to the elements of the various embodiments described throughout the disclosure that are known or later come to be known to those of ordinary skill in the relevant art are intended to be encompassed by the features described and claimed herein.

## Claims

1. A vapor chamber heatsink assembly (300, 800), under vacuum, having a working fluid therein, comprising:
a plurality of heatsink fins (1000, 7000), each, having a fin base (119), an enhancement portion (115), and a fin tip, opposite the fin base (119); and
a vapor chamber (390, 790) having:
an upper casing (190) comprising:
a mounting surface having a plurality of mounting portions (192) thereon; and
an upper chamber surface (191, 191a), opposite the mounting surface,
whereby the plurality of heatsink fins (1000, 7000) are disposed on the upper casing (190) at the plurality of mounting portions (192), respectively; and
a lower casing (290) comprising:
a lower chamber surface (291, 291a); and
a contact surface (199), opposite the lower chamber surface (291, 291a),
wherein the upper chamber surface (191, 191a) is liquid tight attached to the lower chamber surface (291, 291a), and
wherein the upper and lower chamber surfaces (191, 191a, 291, 291a) form a plurality of obstructers (114, 214, 214a) defining a plurality of braided channels (116, 116b, 216, 216a) therearound in direct or indirect communication thereamong,
whereby the working fluid, in use, travels through the plurality of braided channels (116, 116b, 216, 216a) unobstructed, **characterized in that** each of the plurality of heatsink fins (1000, 7000) comprises a plurality of channel extensions (1194) therein in direct or indirect communication thereamong and in direct or indirect communication with the plurality of braided channels (116, 116b, 216, 216a) of the upper and lower chamber surfaces (191, 191a, 291, 291a).

2. The vapor chamber heatsink assembly (300, 800) of claim 1, further comprising:
a first heat source (182); and
a second heat source (188),
wherein the first and second heat sources (182, 188) are mounted to the contact surface (199) of the lower chamber surface (291, 291a), each opposite to at least two opposing directions of one of the plurality of braided channels (116, 116b, 216, 216a) of the upper and lower chamber surfaces (191, 191a, 291, 291a), respectively.

3. The vapor chamber heatsink assembly (300, 800) of claim 2, wherein the power requirement and maximum operating temperature allowance of the first heat source (182) is less than the power requirement and maximum operating temperature allowance of the second heat source (188), whereby, during operation, the working fluid travels through the at least two opposing directions of the plurality of braided channels (116, 116b, 216, 216a) opposite to the mounted first and second heat sources (182, 188), respectively, while concurrently, being hindered to agglomerate to the second heat source (188) via the plurality of obstructers (114, 214, 214a).

4. The vapor chamber heatsink assembly (300, 800) of one of claims 1 to 3, wherein the shape of each of the plurality of obstructers (114, 214, 214a) is a four-sided shape, and each is separated by coinciding plurality of braided channels (116, 116b, 216, 216a) of neighboring plurality of obstructers (114, 214, 214a) or perimeter walls therearound, whereby at least one corner of each of the plurality of obstructers (114, 214, 214a) define a corner of a cross-section of the plurality of braided channels (116, 116b, 216, 216a).

5. The vapor chamber heatsink assembly (300, 800) of one of claims 1 to 4, wherein the amount of the plurality of obstructers (114, 214, 214a) is two and the plurality of braided channels (116, 116b, 216, 216a) comprises one direct communication plurality of braided channels (116, 116b, 216, 216a) having at least four curved flow path changes.

6. The vapor chamber heatsink assembly (300, 800) of one of claims 1 to 5, wherein the plurality of obstructers (114, 214, 214a) defining the plurality of braided channels (116, 116b, 216, 216a) is formed within the upper and lower chamber surfaces, respectively.

7. The vapor chamber heatsink assembly (300, 800) of one of claims 1 to 5, wherein the plurality of obstructers (114, 214, 214a) defining the plurality of braided channels (116, 116b, 216, 216a) is formed within the upper chamber surface (191, 191a), respectively.

8. The vapor chamber heatsink assembly (300, 800) of one of claims 1 to 5, wherein the plurality of obstructers (114, 214, 214a) defining the plurality of braided channels (116, 116b, 216, 216a) is formed within the lower chamber surface (291, 291a), respectively.

9. The vapor chamber heatsink assembly (300, 800) of one of claims 1 to 8, wherein a side of each of the plurality of braided channels (116, 116b, 216, 216a) opposite the contact surface (199) of the lower chamber surface (291, 291a) comprises a wick structure thereon, respectively.

10. The vapor chamber heatsink assembly (300, 800) of claim 9, wherein the wick structure comprises at least one of a porous polymer wick structure, micro groove wick structure, metal mesh wick structure, sintered powder wick structure or sintered ceramic powder wick structure, or any combination of the foregoing.

11. The vapor chamber heatsink assembly (300, 800) of claim 10, wherein at least two of the plurality of channel extensions (1194) of each of the plurality of heatsink fins (1000, 7000) is in direct communication with at least two of the plurality of braided channels (116, 116b, 216, 216a), respectively.

12. The vapor chamber heatsink assembly (300, 800) of one of claims 10 or 11, wherein at least two of the plurality of channel extensions (1194) of each of the plurality of heatsink fins (1000, 7000) are parallel disposed and evenly spaced apart, having a same flow volume and shape.

13. The vapor chamber heatsink assembly (300, 800) of one of claims 1 to 12, wherein each of the plurality of braided channels (216a) comprises a plurality of supporting channel walls (914) and a plurality of filler reserve gaps (816), the plurality of filler reserve gaps (816) configured to contain excess filler material following liquid tight attachment of the upper chamber surface (191, 191a) to the lower chamber surface (291a), the plurality of supporting channel walls is on all sides of the plurality of braided channels (216a), separated from the plurality of obstructers (214a) and perimeter walls via the plurality of filler reserve gaps (816).

14. The vapor chamber heatsink assembly (300, 800) of one of claims 1 to 13 wherein each of the plurality of heatsink fins (1000, 7000) is disposed on the upper casing (190) at the plurality of mounting portions (192) via brazing, respectively.

15. The vapor chamber heatsink assembly (300, 800) of one of claims 1 to 13, wherein the plurality of heatsink fins (1000, 7000) is integrally formed on the upper casing (190) at the plurality of mounting portions (192).

## Patentansprüche

1. Eine unter Vakuum stehende Dampfkammer-Kühlkörper-Anordnung (300, 800) mit einem Arbeitsfluid darin, umfassend:
eine Vielzahl von Kühlkörperrippen (1000, 7000), die jeweils eine Rippenbasis (119), einen Verstärkungsabschnitt (115) und eine Rippenspitze gegenüber der Rippenbasis (119) aufweisen; und
eine Dampfkammer (390, 790) mit:
einem oberen Gehäuse (190), umfassend:
eine Montageoberfläche mit einer Vielzahl von Montageabschnitten (192) darauf; und
eine obere Kammeroberfläche (191, 191a), die der Montageoberfläche gegenüberliegt,
wobei die Vielzahl von Kühlkörperrippen (1000, 7000) auf dem oberen Gehäuse (190) jeweils an der Vielzahl von Befestigungsabschnitten (192) angeordnet ist; und
ein unteres Gehäuse (290), umfassend:
eine untere Kammeroberfläche (291, 291a); und
eine Kontaktoberfläche (199), die der unteren Kammeroberfläche (291, 291a) gegenüberliegt,
wobei die obere Kammeroberfläche (191, 191a) flüssigkeitsdicht an der unteren Kammeroberfläche (291, 291a) befestigt ist, und
wobei die obere und die untere Kammeroberfläche (191, 191a, 291, 291a) eine Vielzahl von Hindernissen (114, 214, 214a) ausbilden, die eine Vielzahl von geflechtartigen Kanälen (116, 116b, 216, 216a), die in direkter oder indirekter Verbindung miteinander stehen, um sie herum definieren, wodurch das Arbeitsfluid im Einsatz ungehindert durch die Vielzahl von geflochtenen Kanälen (116, 116b, 216, 216a) fließt,
**dadurch gekennzeichnet, dass** jede der Vielzahl von Kühlkörperrippen (1000, 7000) darin eine Vielzahl von Kanalverlängerungen (1194) umfasst, die in direkter oder indirekter Verbindung miteinander und in direkter oder indirekter Verbindung mit der Vielzahl von geflechtartigen Kanälen (116, 116b, 216, 216a) der oberen und unteren Kammeroberflächen (191, 191a, 291, 291a) stehen.

2. Die Dampfkammer-Kühlkörper-Anordnung (300, 800) nach Anspruch 1, weiter umfassend:
eine erste Wärmequelle (182); und
eine zweite Wärmequelle (188),
wobei die erste und die zweite Wärmequelle (182, 188) an der Kontaktoberfläche (199) der unteren Kammeroberfläche (291, 291a) jeweils gegenüberliegend an mindestens zwei entgegengesetzten Richtungen eines der Vielzahl von geflechtartigen Kanälen (116, 116b, 216, 216a) der oberen bzw. der unteren Kammeroberflächen (191, 191a, 291, 291a) angebracht sind.

3. Die Dampfkammer-Kühlkörper-Anordnung (300, 800) nach Anspruch 2, wobei der Leistungsbedarf und die maximal zulässige Betriebstemperatur der ersten Wärmequelle (182) geringer ist als der Leistungsbedarf und die maximal zulässige Betriebstemperatur der zweiten Wärmequelle (188), wodurch das Arbeitsfluid während des Betriebs durch die mindestens zwei entgegengesetzten Richtungen der Vielzahl von geflechtartigen Kanälen (116, 116b, 216, 216a) gegenüber der montierten ersten bzw. zweiten Wärmequelle (182, 188) strömt, während es gleichzeitig daran gehindert ist, über die Vielzahl von Hindernissen (114, 214, 214a) zur zweiten Wärmequelle (188) zu agglomerieren.

4. Die Dampfkammer-Kühlkörper-Anordnung (300, 800) nach einem der Ansprüche 1 bis 3, wobei die Form jedes der Vielzahl von Hindernissen (114, 214, 214a) eine vierseitige Form ist und jedes durch eine zusammenfallende Vielzahl von geflechtartigen Kanälen (116, 116b, 216, 216a) der benachbarten Vielzahl von Hindernissen (114, 214, 214a) oder Umfangswände um diese herum getrennt sind, wobei mindestens eine Ecke jedes der Vielzahl von Hindernissen (114, 214, 214a) eine Ecke eines Querschnitts der Vielzahl von geflechtartigen Kanälen (116, 116b, 216, 216a) definiert.

5. Die Dampfkammer-Kühlkörper-Anordnung (300, 800) nach einem der Ansprüche 1 bis 4, wobei die Anzahl der Vielzahl von Hindernissen (114, 214, 214a) zwei beträgt und die Vielzahl von geflechtartigen Kanälen (116, 116b, 216, 216a) eine direkte Verbindung der Vielzahl von geflechtartigen Kanälen (116, 116b, 216, 216a) mit mindestens vier gekrümmten Strömungswegänderungen umfasst.

6. Die Dampfkammer-Kühlkörper-Anordnung (300, 800) nach einem der Ansprüche 1 bis 5, wobei die Vielzahl von Hindernissen (114, 214, 214a), die die Vielzahl von geflechtartigen Kanälen (116, 116b, 216, 216a) definieren, innerhalb der oberen bzw. unteren Kammeroberflächen ausgebildet ist.

7. Die Dampfkammer-Kühlkörper-Anordnung (300, 800) nach einem der Ansprüche 1 bis 5, wobei die Vielzahl von Hindernissen (114, 214, 214a), die die Vielzahl von geflechtartigen Kanälen (116, 116b, 216, 216a) definieren, jeweils innerhalb der oberen Kammeroberfläche (191, 191a) ausgebildet ist.

8. Die Dampfkammer-Kühlkörper-Anordnung (300, 800) nach einem der Ansprüche 1 bis 5, wobei die Vielzahl von Hindernissen (114, 214, 214a), die die Vielzahl von geflechtartigen Kanälen (116, 116b, 216, 216a) definieren, jeweils innerhalb der unteren Kammeroberfläche (291, 291a) ausgebildet ist.

9. Die Dampfkammer-Kühlkörper-Anordnung (300, 800) nach einem der Ansprüche 1 bis 8, wobei eine Seite jedes der Vielzahl von geflechtartigen Kanäle (116, 116b, 216, 216a) gegenüber der Kontaktoberfläche (199) der unteren Kammeroberfläche (291, 291a) jeweils eine Dochtstruktur darauf aufweist.

10. Die Dampfkammer-Kühlkörper-Anordnung (300, 800) nach Anspruch 9, wobei die Dochtstruktur mindestens eine poröse Polymer-Dochtstruktur, eine Mikrorillen-Dochtstruktur, eine Metallnetz-Dochtstruktur, eine Sinterpulver-Dochtstruktur oder eine gesinterte Keramikpulver-Dochtstruktur oder eine beliebige Kombination der vorgenannten umfasst.

11. Die Dampfkammer-Kühlkörper-Anordnung (300, 800) nach Anspruch 10, wobei mindestens zwei der Vielzahl von Kanalverlängerungen (1194) von jeder Vielzahl von Kühlkörper-Rippen (1000, 7000) in direkter Verbindung mit mindestens zwei der Vielzahl von geflechtartigen Kanälen (116, 116b, 216, 216a) stehen.

12. Die Dampfkammer-Kühlkörper-Anordnung (300, 800) nach einem der Ansprüche 10 oder 11, wobei mindestens zwei der Vielzahl von Kanalverlängerungen (1194) jeder Vielzahl von Kühlkörper-Rippen (1000, 7000) parallel angeordnet und gleichmäßig voneinander beabstandet sind, und so ein gleiches Strömungsvolumen und eine gleiche Form aufweisen.

13. Die Dampfkammer-Kühlkörper-Anordnung (300, 800) nach einem der Ansprüche 1 bis 12, wobei jeder der Vielzahl von geflechtartigen Kanälen (216a) eine Vielzahl von stützenden Kanalwänden (914) und eine Vielzahl von Füllstoff-Reservelücken (816) umfasst, wobei die Vielzahl von Füllstoff-Reservelücken (816) so ausgebildet ist, um nach der flüssigkeitsdichten Befestigung der oberen Kammeroberfläche (191, 191a) an der unteren Kammeroberfläche (291a) überschüssiges Füllmaterial aufzunehmen, wobei die Vielzahl von stützenden Kanalwänden auf allen Seiten der Vielzahl von geflechtartigen Kanälen (216a) ausgebildet ist, die von der Vielzahl von Hindernissen (214a) und Umfangswänden über die Vielzahl von Füllstoff-Reservelücken (816) getrennt sind.

14. Die Dampfkammer-Kühlkörper-Anordnung (300, 800) nach einem der Ansprüche 1 bis 13, wobei jede der Vielzahl von Kühlkörper-Rippen (1000, 7000) jeweils durch Hartlöten an der Vielzahl von Befestigungsabschnitten (192) am oberen Gehäuse (190) angeordnet ist.

15. Die Dampfkammer-Kühlkörper-Anordnung (300, 800) nach einem der Ansprüche 1 bis 13, wobei die Vielzahl von Kühlkörper-Rippen (1000, 7000) einstückig an der Vielzahl von Befestigungsabschnitten (192) am oberen Gehäuse (190) ausgebildet ist.

## Revendications

1. Ensemble dissipateur thermique de chambre de vapeur (300, 800), sous vide, disposant d'un fluide de fonctionnement en son sein, comprenant :
une pluralité d'ailettes de dissipateur thermique (1000, 7000), chacune présentant une base d'ailette (119), une partie de renforcement (115) et une extrémité d'ailette, opposée à la base d'ailette (119) ; et
une chambre de vapeur (390, 790) présentant :
un boîtier supérieur (190) comprenant :
une surface de montage présentant une pluralité de parties de montage (192) sur celle-ci ; et
une surface de chambre supérieure (191, 191a), opposée à la surface de montage, par laquelle la pluralité d'ailettes de dissipateur thermique (1000, 7000) est disposée sur le boîtier supérieur (190) au niveau de la pluralité de parties de montage (192), respectivement ; et
un boîtier inférieur (290) comprenant :
une surface de chambre inférieure (291, 291a) ; et
une surface de contact (199), opposée à la surface de chambre inférieure (291, 291a),
dans lequel la surface de chambre supérieure (191, 191a) est rattachée en étanchéité aux liquides à la surface de chambre inférieure (291, 291a), et
dans lequel les surfaces de chambre supérieure et inférieure (191, 191a, 291, 291a) constituent une pluralité d'obturateurs (114, 214, 214a) définissant une pluralité de canaux tressés (116, 116b, 216, 216a) autour de ceux-ci en communication directe ou indirecte les uns entre eux,
par lequel le fluide de fonctionnement, en exploitation, circule à travers la pluralité de canaux tressés (116, 116b, 216, 216a) non obstrués, **caractérisé en ce que** chacune de la pluralité d'ailettes de dissipateur thermique (1000, 7000) comprend une pluralité d'extensions de canal (1194) en son sein en communication directe ou indirecte entre elles et en communication directe ou indirecte avec la pluralité de canaux tressés (116, 116b, 216, 216a) des surfaces de chambre supérieure et inférieure (191, 191a, 291, 291a).

2. L'ensemble dissipateur thermique de chambre de vapeur (300, 800) de la revendication 1, comprenant en outre :
une première source de chaleur (182) ; et
une deuxième source de chaleur (188),
dans lequel les première et deuxième sources de chaleur (182, 188) sont montées sur la surface de contact (199) de la surface de chambre inférieure (291, 291a), chacune opposée à au moins deux directions opposées d'un de la pluralité de canaux tressés (116, 116b, 216, 216a) des surfaces de chambre supérieure et inférieure (191, 191a, 291, 291a), respectivement.

3. L'ensemble dissipateur thermique de chambre de vapeur (300, 800) de la revendication 2,
dans lequel l'exigence énergétique et la température de fonctionnement maximale admissibles de la première source de chaleur (182) sont inférieures à l'exigence énergétique et la température de fonctionnement maximale admissibles de la deuxième source de chaleur (188),
par lequel, en cours de fonctionnement, le fluide de fonctionnement circule à travers les aux moins deux directions opposées de la pluralité de canaux tressés (116, 116b, 216, 216a) opposée aux première et deuxième sources de chaleur montées (182, 188), respectivement,
tout en étant simultanément empêché de s'agglomérer vers la deuxième source de chaleur (188) via la pluralité d'obturateurs (114, 214, 214a).

4. L'ensemble dissipateur thermique de chambre de vapeur (300, 800) de l'une des revendications 1 à 3, dans lequel la forme de chacun de la pluralité d'obturateurs (114, 214, 214a) est une forme à quatre côtés, et chacun est séparé par une pluralité coïncidente de canaux tressés (116, 116b, 216, 216a) d'une pluralité voisine d'obturateurs (114, 214, 214a) ou de parois de périmètre autour de ceux-ci, par lequel au moins un coin de chacun de la pluralité d'obstructeurs (114, 214, 214a) définit un coin d'une section transversale de la pluralité de canaux tressés (116, 116b, 216, 216a).

5. L'ensemble de dissipateur thermique de chambre de vapeur (300, 800) de l'une des revendications 1 à 4, dans lequel la quantité de la pluralité d'obturateurs (114, 214, 214a) est de deux et la pluralité de canaux tressés (116, 116b, 216, 216a) comprend une pluralité en communication directe de canaux tressés (116, 116b, 216, 216a) présentant au moins quatre changements de trajet de flux incurvés.

6. L'ensemble de dissipateur thermique de chambre de vapeur (300, 800) de l'une des revendications 1 à 5, dans lequel la pluralité d'obturateurs (114, 214, 214a) définissant la pluralité de canaux tressés (116, 116b, 216, 216a) est constituée au sein des surfaces de chambre supérieure et inférieure, respectivement.

7. L'ensemble de dissipateur thermique de chambre de vapeur (300, 800) de l'une des revendications 1 à 5, dans lequel la pluralité d'obturateurs (114, 214, 214a) définissant la pluralité de canaux tressés (116, 116b, 216, 216a) est constituée au sein de la surface de chambre supérieure (191, 191a), respectivement.

8. L'ensemble de dissipateur thermique de chambre de vapeur (300, 800) de l'une des revendications 1 à 5, dans lequel la pluralité d'obturateurs (114, 214, 214a) définissant la pluralité de canaux tressés (116, 116b, 216, 216a) est constituée au sein de la surface de chambre inférieure (291, 291a), respectivement.

9. L'ensemble de dissipateur thermique de chambre de vapeur (300, 800) de l'une des revendications 1 à 8, dans lequel un côté de chacun de la pluralité de canaux tressés (116, 116b, 216, 216a) opposé à la surface de contact (199) de la surface de chambre inférieure (291, 291a) comprend un réseau capillaire sur celui-ci, respectivement.

10. L'ensemble de dissipateur thermique de chambre de vapeur (300, 800) de la revendication 9, dans lequel le réseau capillaire comprend au moins un d'un réseau capillaire en polymère poreux, d'un réseau capillaire en micro-rayures, d'un réseau capillaire en maillage métallique, d'un réseau capillaire en poudre frittée ou d'un réseau capillaire en poudre de céramique frittée, ou d'une quelconque combinaison des précédents.

11. L'ensemble de dissipateur thermique de chambre de vapeur (300, 800) de la revendication 10, dans lequel au moins deux de la pluralité d'extensions de canal (1194) de chacune de la pluralité d'ailettes de dissipateur thermique (1000, 7000) est en communication directe avec au moins deux de la pluralité de canaux tressés (116, 116b, 216, 216a), respectivement.

12. L'ensemble de dissipateur thermique de chambre de vapeur (300, 800) de l'une des revendications 10 ou 11, dans lequel au moins deux de la pluralité d'extensions de canal (1194) de chacune de la pluralité d'ailettes de dissipateur thermique (1000, 7000) sont disposées parallèlement et espacées régulièrement, présentant des mêmes forme et volume d'écoulement.

13. L'ensemble de dissipateur thermique de chambre de vapeur (300, 800) de l'une des revendications 1 à 12, dans lequel chacun de la pluralité de canaux tressés (216a) comprend une pluralité de parois de canal (914) et une pluralité de vides de réserve de matériau de remplissage (816), la pluralité de vides de réserve de matériau de remplissage (816) configurée pour contenir un matériau de remplissage en excédent suite au rattachement en étanchéité aux liquides de la surface de chambre supérieure (191, 191a) à la surface de chambre inférieure (291a), la pluralité de parois de canal de soutien se trouve sur tous les côtés de la pluralité de canaux tressés (216a), séparée de la pluralité d'obturateurs (214a) et de parois de périmètre via la pluralité de vides de réserve de matériau de remplissage (816) .

14. L'ensemble de dissipateur thermique de chambre de vapeur (300, 800) de l'une des revendications 1 à 13 dans lequel chacune de la pluralité d'ailettes de dissipateur thermique (1000, 7000) est disposée sur le boîtier supérieur (190) au niveau de la pluralité de parties de montage (192) via un brasage, respectivement.

15. L'ensemble de dissipateur thermique de chambre de vapeur (300, 800) de l'une des revendications 1 à 13, dans lequel la pluralité d'ailettes de dissipateur thermique (1000, 7000) est intégralement formée sur le boîtier supérieur (190) au niveau de la pluralité de parties de montage (192).
